# FASCICULE DE BREVET EUROPEEN

(11) **EP 3 859 769 B1**
(45) Date de publication et mention de la délivrance du brevet: **26.06.2024**
(21) Numéro de dépôt: 21153243.7
(22) Date de dépôt: 25.01.2021
(51) Int. Cl.: H01L 21/3065, H01L 29/78, H01L 29/06, B82Y 10/00, H01L 29/161, H01L 29/66, H01L 29/739, H01L 29/775, H01L 29/786

(54) **PROCEDE DE GRAVURE A L'ECHELLE NANOMETRIQUE D'UN ALLIAGE GERMANIUM ETAIN (GESN) POUR TRANSISTOR A EFFET DE CHAMP**
VERFAHREN ZUM ÄTZEN IM NANOMETERBEREICH EINER GERMANIUM-ZINN-LEGIERUNG (GESN) FÜR FET-TRANSISTOR
METHOD FOR ETCHING IN NANOMETRIC SCALE A GERMANIUM-TIN (GESN) ALLOY FOR FET TRANSISTOR

(30) Priorité: 31.01.2020 FR 2000967
(43) Date de publication de la demande: 04.08.2021
(73) Titulaire: Commissariat à l'Energie Atomique et aux Energies Alternatives, 75015 Paris (FR); Centre national de la recherche scientifique, 75016 Paris (FR)
(72) Inventeur: EUSTACHE, Etienne, 71100 CHALON SUR SAONE (FR); SALEM, Bassem, 38360 SASSENAGE (FR); HARTMANN, Jean-Michel, 38054 GRENOBLE Cedex 09 (FR); BASSANI, Franck, 38130 ECHIROLLES (FR); MAHJOUB, Mohamed-Aymen, 63000 CLERMONT-FERRAND (FR)
(74) Mandataire: Atout PI Laplace

(56) Documents cités:
- US-A1- 2014 138 744
- MILORD L ET AL: "Inductively coupled plasma etching of germanium tin for the fabrication of photonic components", PROCEEDINGS OF SPIE; [PROCEEDINGS OF SPIE ISSN 0277-786X VOLUME 10524], SPIE, US, vol. 10108, 20 février 2017 (2017-02-20), pages 101080C-101080C, XP060088412, DOI: 10.1117/12.2252280 ISBN: 978-1-5106-1533-5
- SHANG COLLEEN K ET AL: "Dry-wet digital etching of Ge1-xSnx", APPLIED PHYSICS LETTERS, A I P PUBLISHING LLC, US, vol. 108, no. 6, 8 février 2016 (2016-02-08), XP012204872, ISSN: 0003-6951, DOI: 10.1063/1.4941800 [extrait le 1901-01-01]

## Description

### Domaine technique de l'invention

La présente invention concerne le domaine de la réalisation de Transistors à Effet de Champ (« FET » pour « Field Effet Transistor » en anglais) comprenant des canaux de conduction. Plus précisément, l'invention concerne un procédé de gravure d'un alliage germanium-étain, en particulier pour réaliser des canaux de conduction pour transistor FET.

L'invention s'applique notamment à la réalisation de transistors à effet de champ à ailettes ou dérives (FinFET pour « Fin Field Effect Transistor » en anglais), de transistors à effet de champ à grille enrobante (GAAFET pour « Gâte All Around Field Effect Transistor » en anglais), ou encore de transistors FET à effet Tunnel (« TFET » pour « Tunnel FET » en anglais).

De manière générale, l'invention s'applique à la réalisation de transistors avantageusement destinés à des applications logiques à hautes performances et basse consommation de la microélectronique, et/ou pouvant être utilisé pour des applications Internet des Objets (« IoT » pour « Internet Of Things » en anglais).

### Etat de la technique

Le transistor à effet de champ à structure métal-oxyde-semiconducteur (MOSFET pour « Metal-Oxyde-Semiconductor Field Effet Transistor » en anglais) est un des transistors les plus couramment utilisés aujourd'hui dans les applications micro-électroniques. Il permet de contrôler le passage d'un courant entre deux zones dites de source et de drain. Il comporte plusieurs éléments de base :
- un canal semi-conducteur qui sert de zone de conduction, ce canal peut être nommé « canal de conduction » ;
- des zones de source et drain aux deux extrémités du canal ;
- une grille métallique (ou « gâte » en anglais) intercalée d'un isolant (l'oxyde de grille) qui permet de contrôler la conduction du courant.

Depuis la réalisation des premiers transistors MOSFET, la taille de ceux-ci a fortement diminué. Cependant, les concepteurs se heurtent à des limites physiques de plus en plus contraignantes au niveau des dimensions (la dimension de la grille notamment ne pourra pas être diminuée éternellement), de la précision des procédés de fabrication, des matériaux et des phénomènes physiques parasites. Par exemple, les transistors de taille réduite présentent des effets parasites, liés aux effets de canaux courts et à une mauvaise dissipation de la chaleur dégagée lors du fonctionnement des MOSFET miniaturisés.

Les solutions technologiques pour contourner et/ou compenser ces effets parasites sont notamment les architectures particulières, dites « multi-grilles » ou « 3D », qui comportent une grille enrobant le canal de manière partielle ou totale. Ces architectures particulières permettent d'améliorer le contrôle électrostatique du canal, limitant ainsi les effets de canaux courts. Cette amélioration du contrôle électrostatique est proportionnelle à la surface de grille qui recouvre le canal. De plus, ces architectures permettent d'augmenter la densification des transistors puisqu'elles permettent de réaliser des empilements de transistors et ainsi de profiter de la dimension verticale d'une puce contrairement à la conception standard qui occupe principalement le plan horizontal.

Les transistors de type FinFET et GAAFET font partie de la famille des transistors dits « multi-grilles » ou « 3D » qui permettent donc d'améliorer le contrôle électrostatique du canal de conduction par la grille.

Un transistor à effet de champ à ailettes ou dérives (« FinFET » pour « Fin Field Effect Transistor ») est un transistor construit sur un substrat où la grille est placée sur deux, trois ou quatre côtés du canal ou enroulée autour du canal, formant une structure multi-grilles. Le nom générique provient du fait que le canal de conduction et notamment la région source / drain forme des ailettes ou « dérives » (« fin » en anglais) sur la surface de substrat. Les transistors FinFET ont des temps de commutation très courts et une densité de courant élevée.

Un transistor à effet de champ à grille enrobante (« GAAFET » pour « Gâte All Around Field Effect Transistor » en anglais) est un transistor dans lequel le canal de conduction est entièrement entouré par la grille, où le contrôle électrostatique est le maximal. Cette configuration a pour avantage d'offrir un bon compromis entre le contrôle électrostatique du canal par la grille et le courant de commande obtenus.

Un transistor GAAFET peut être formé par la superposition d'un ou de plusieurs nanofils ou nano-couches, chacun formant un canal entouré par la grille. Les nanofils peuvent être disposés horizontalement ou verticalement.

Malgré ces architectures particulières, à mesure que les dimensions des transistors continuent à diminuer, la faible mobilité des matériaux en silicium (Si) devient un facteur majeur limitant ses performances. Afin de maintenir voire d'améliorer les performances du transistor tout en diminuant ses dimensions, il est paru nécessaire d'utiliser des matériaux de canal qui ont une mobilité plus élevée que le silicium. Il est connu d'utiliser du germanium (Ge) ou un alliage silicium-germanium (SiGe) comme matériaux de canal. Le germanium a quatre fois plus de mobilité que Si.

Plus récemment, les alliages germanium-étain (GeSn ou Ge₁₋ₓSnₓ) sont apparus comme des candidats prometteurs pour réaliser des transistors MOSFET à hautes performances et à faible consommation d'énergie. Comparé au silicium ou au germanium pur, le Ge₁₋ₓSnₓ possède un gap d'énergie plus petit, des masses effectives des porteurs plus faibles, une mobilité des porteurs plus importante ainsi qu'une transition d'un gap indirect à un gap direct pour des concentrations d'étain (Sn) supérieures à environ 8% (c'est-à-dire pour x supérieur à 8%).

Plus précisément, en augmentant la valeur x, c'est à dire la concentration en étain, l'énergie de bande interdite du Ge₁₋ₓSnₓ peut être diminuée, la masse effective des porteurs peut être plus faible et la mobilité des porteurs peut être plus élevée. Cela permet notamment d'appliquer des faibles tensions à la grille et d'obtenir des transistors à basse consommation.

Ainsi, il s'est avéré très intéressant d'utiliser des structures multi-grilles en alliages GeSn afin de combiner les avantages d'un tel matériau avec les avantages de ces architectures multi-grilles en termes de contrôle électrostatique du canal. Notamment il s'est avéré essentiel de réaliser des nanofils verticaux et horizontaux, ou encore des ailettes ou dérives en GeSn.

Par ailleurs, afin de limiter davantage la consommation d'énergie, le transistor à effet tunnel (TFET) peut être utilisé. La structure de base d'un TFET est proche de celle d'un MOSFET à la différence près que la source et le drain du TFET sont dopés de types opposés. Une structure courante de TFET est une jonction P-I-N (dopé-P, Intrinsèque, dopé-N). Le potentiel électrostatique de la jonction intrinsèque est contrôlé par la grille. Le TFET peut permettre une polarisation avec de plus faibles tensions d'alimentation. Cependant, le TFET possède un courant à l'état passant plus faible qu'un MOSFET classique. Ce courant étant directement lié à la masse effective des porteurs ainsi qu'à l'énergie de la bande interdite du matériau utilisé, les alliages GeSn s'avèrent également particulièrement intéressants pour les TFET et surtout comme matériau pour l'électrode « source ». Récemment, de nombreux progrès ont été réalisés concernant la croissance épitaxiale d'alliages GeSn, notamment par dépôt chimique en phase vapeur (« CVD » pour Chemical Vapor Deposition en anglais) ou par jets moléculaires (« MBE » pour Molecular Beam Epitaxy en anglais). Les alliages GeSn sont développés typiquement sur une couche de Ge elle-même déposée sur un substrat, typiquement un substrat de silicium.

En plus de la haute qualité cristalline nécessaire des alliages GeSn, il est essentiel de développer des procédés de gravure de GeSn, et notamment des procédés de gravures de GeSn qui permettent d'obtenir des dérives (fins) ou des nanofils à base de Ge₁₋ₓSnₓ de dimensions de l'ordre de la dizaine de nanomètres à quelques dizaines de nanomètres, notamment lorsque x est supérieur à 8%, et a fortiori lorsque x est supérieur ou égal à 10%.

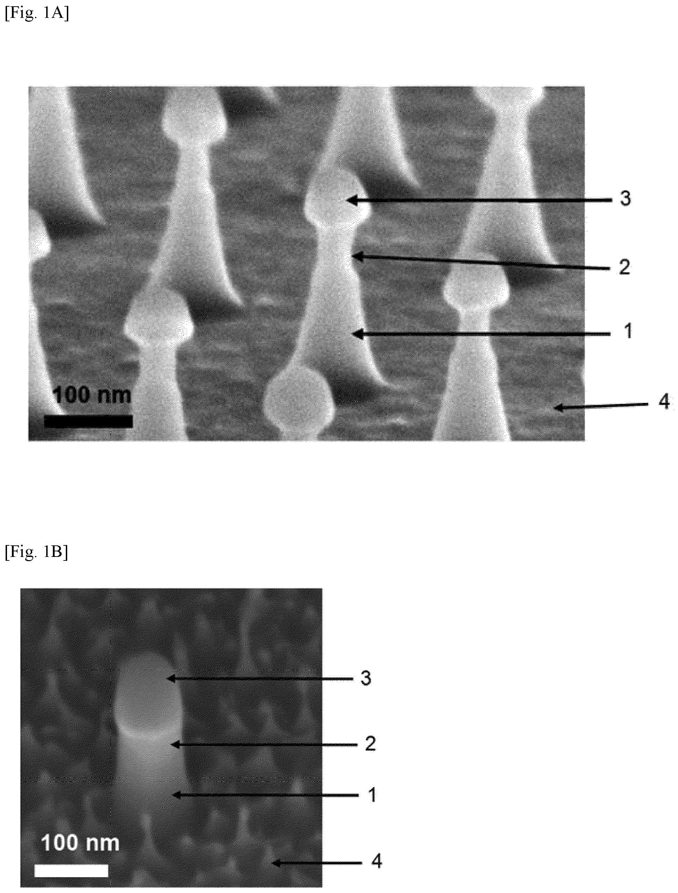

Les procédés connus de gravure à base de Cl₂ ne permettent pas de former des flancs de gravure droits et lisses. Au contraire, les procédés de gravure connus ont tendance à réaliser des flancs de gravure à forte rugosité et/ou à réaliser des gravures différentes (c'est-à-dire sur des profondeurs différentes) entre la couche 1 de Ge et la couche 2 de GeSn, comme cela est illustré en figure 1A où l'on voit que la gravure est plus profonde pour le GeSn que pour le Ge. Or, il est essentiel d'avoir des flancs gravés à faible rugosité pour optimiser la conductivité du canal en GeSn, en maximisant la vitesse des porteurs de charge.

En outre, les procédés connus de gravure ont tendance à laisser un fond de gravure 4 non lisse, c'est-à-dire un fond de gravure présentant des aiguilles, comme cela est illustré en figure 1B. Or il est essentiel d'avoir un fond de gravure le plus lisse possible, c'est-à-dire qui présente le moins d'aiguilles possible, de manière à enchaîner de manière reproductible et fiable les étapes technologiques nécessaires à la réalisation des transistors.

Ces phénomènes de flancs à forte rugosité et/ou de fonds de gravure à aiguilles ont tendance à s'amplifier lorsque le pourcentage x en étain dans l'alliage Ge₁₋ₓSnₓ augmente.

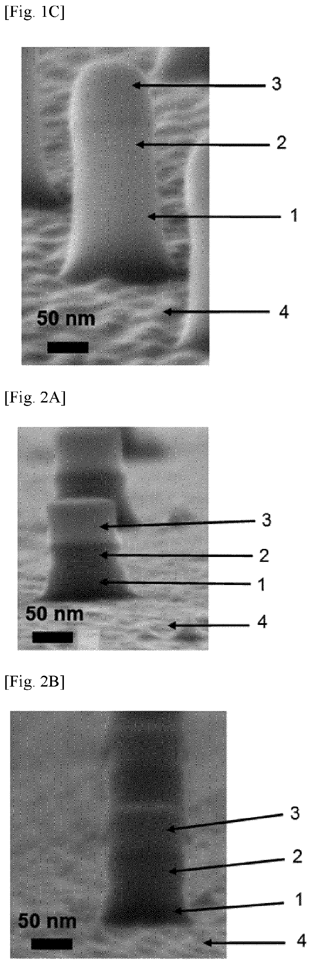

Dans ce contexte, il est en particulier essentiel de disposer d'un procédé amélioré de gravure d'alliages Ge₁₋ₓSnₓ avec x strictement supérieur à 0% et strictement inférieur à 30% qui permette d'obtenir des flancs de gravure à faible rugosité et des gravures sur des profondeurs équivalentes entre le Ge et le Ge₁₋ₓSnₓ ainsi qu'un fond de gravure lisse, comme cela est illustré en figure 1C. En particulier, x est compris entre 6% et 15%, et de préférence x est supérieur à 8%.

A ce sujet, référence est faite aux documents suivants:
- MILORD L ET AL: "Inductively coupled plasma etching of germanium tin for the fabrication of photonic components", PROCEEDINGS OF SPIE, vol. 10108, 20 février 2017, pages 101080C-101080C;
- US 2014/138744 A1 (KOTLYAR) 22 mai 2014;
- SHANG COLLEEN K ET AL: "Dry-wet digital etching of Gel-xSnx", APPLIED PHYSICS LETTERS, vol. 108, no. 6, 8 février 2016.

L'invention vise à disposer d'un procédé de gravure de Ge₁₋ₓSnₓ qui permette d'obtenir une faible rugosité des flancs de gravure et un fond de gravure le plus lisse possible, et ce, même pour des pourcentages x en étain supérieurs à 8%.

### Expose de l'invention

L'invention est définie par l'objet de la revendication 1. Des modes de réalisation préférentiels sont exposés dans les revendications dépendantes.

L'objet de l'invention permettant de remédier à ces inconvénients est un procédé de gravure à l'échelle nanométrique d'une couche de Ge₁₋ₓSnₓ sur un support pour transistor FET, x étant la concentration en étain, le procédé de gravure étant caractérisé en ce qu'il comprend :
- une étape de retrait de l'oxyde natif ou chimique de l'étain ; et
- une étape de gravure plasma de ladite couche de Ge₁₋ₓSnₓ avec un mélange comprenant du dichlore (Cl₂), et du diazote (N₂) et sous une pression de gravure inférieure ou égale à 50 mTorr, de préférence inférieure ou égale à 10 mTorr, ce qui correspond à 1,333 Pa ;
ladite étape de retrait étant antérieure à ladite étape de gravure plasma.

Il est précisé qu'un Torr est équivalent à 133,322 Pa et donc qu'un mTorr est équivalent à 0,133322 Pa.

Le support peut être : un isolant, un substrat de silicium ou de silicium sur isolant (SOI), un substrat de germanium, un substrat en silicium recouvert d'une couche de germanium, un substrat de germanium sur isolant ou tout autre substrat à base de semi-conducteurs III-V (par exemple : GaAs, InP). Le support comprend de préférence comme dernière couche du Ge (de telle sorte que la couche d'alliage GeSn soit sur du Ge).

La concentration x en étain dans l'alliage Ge₁₋ₓSnₓ est sensiblement inférieure à 30%. Par sensiblement, on entend 30% ± 10%. Cette concentration x en étain dans l'alliage GeSn permet d'autoriser l'obtention d'une couche GeSn cristalline. En outre, la concentration x en étain dans l'alliage Ge₁₋ₓSnₓ est de préférence strictement supérieure à 0%.

Selon un mode particulier de l'invention, la concentration x en étain dans l'alliage Ge₁₋ₓSnₓ est sensiblement inférieure à 30% ± 3%.

La température de l'étape de gravure est inférieure à 50°C et de préférence à température ambiante. Le procédé de gravure selon l'invention, en combinant une chimie de plasma adaptée (mélange de dichlore Cl₂ et diazote N₂, éventuellement avec du dioxygène O₂) avec une très faible pression (inférieure à 50 mTorr, de préférence inférieure ou égale à 10 mTorr) permet d'obtenir des dérives (« fins » en anglais) ou des nanofils à base de Ge₁₋ₓSnₓ de dimensions de l'ordre de quelques nanomètres à quelques dizaines de nanomètres, et ce, avec des flancs de gravure à faible rugosité, et un fond de gravure lisse, c'est-à-dire, sans aiguilles, même lorsque x est supérieur à 8%. Une « chimie » désigne un mélange de gaz pour réaliser une gravure.

Le mélange Cl₂ et N₂ permet la gravure du matériau Ge₁₋ₓSnₓ tandis que l'O₂ permet d'assurer une bonne verticalité de gravure grâce à une passivation des flancs.

Selon un mode de réalisation, la concentration x en étain dans le Ge₁₋ₓSnₓ est supérieure à 5 %, de préférence supérieure ou égale à 10%.

Selon un mode de réalisation, la pression de gravure est inférieure ou égale à 10 mTorr pour une concentration x en étain inférieure à 8% et elle est inférieure ou égale à 5 mTorr pour une concentration x en étain supérieure ou égale à 8%.

Selon un mode de réalisation, la pression de gravure est inférieure ou égale à 2 mTorr pour une concentration x en étain supérieure ou égale à 15%.

Selon un mode de réalisation, le mélange comprenant en outre du dioxygène (O₂).

De préférence, si la concentration x en étain dans l'alliage GeSn est supérieure à 10%, le mélange consiste en un mélange de Cl₂ et N₂ sans O₂.

De préférence, si la concentration x en étain dans l'alliage GeSn est inférieure à 10%, le mélange consiste en un mélange de Cl₂, N₂ et O₂.

Selon l'invention, le procédé de gravure comprend une étape de retrait de l'oxyde natif ou chimique de l'étain, ladite étape de retrait étant antérieure à l'étape de gravure plasma du Ge₁₋ₓSnₓ. Le fait de réaliser une telle étape de retrait permet d'avoir un profil de gravure moins dégradé, surtout lorsque la concentration x en étain est supérieure ou égale à 15%. Selon un mode de réalisation particulier, l'étape de retrait consiste en une attaque chimique acide, l'acide étant de préférence de l'acide fluorhydrique (HF) ou de l'acide chlorhydrique (HCl). La concentration massique d'acide peut être comprise entre 1 et 37%, de préférence entre 10 et 30%. Selon un mode de réalisation, le procédé de gravure comprend en outre une étape de dépôt d'un masque sur la couche de Ge₁₋ₓSnₓ, de préférence un masque dur, par exemple un masque en résine Hydrogène Silsesquioxane (HSQ), ladite étape de dépôt étant antérieure à l'étape de gravure plasma du Ge₁₋ₓSnₓ.

Selon un mode de réalisation, le procédé de gravure comprend en outre une étape d'élimination du masque, ladite étape d'élimination étant postérieure à l'étape de gravure plasma du Ge₁₋ₓSnₓ.

Un second objet de l'invention est un procédé de fabrication d'au moins un canal de conduction sur un support pour transistor FET, le procédé de fabrication comprenant les étapes suivantes :
- une étape de formation d'une couche en Ge₁₋ₓSnₓ sur ledit support, ladite couche étant réalisée par croissance épitaxiale ;
- une étape de gravure de la couche de Ge₁₋ₓSnₓ réalisée selon le procédé de gravure.

Selon un mode de réalisation, la surface libre du support comprend une couche de Ge de sorte que la couche de Ge₁₋ₓSnₓ soit formée sur la couche de Ge, et le procédé de fabrication comprend en outre une étape de gravure plasma sélective de la couche de Ge, ladite étape de gravure plasma sélective étant réalisée de préférence avec du tétrafluorure de carbone (CF₄), et étant postérieure à l'étape de gravure du Ge₁₋ₓSnₓ.

De préférence, le support est un substrat de silicium ou de silicium sur isolant sur lequel une couche de Ge a été déposée.

L'étape de gravure plasma sélective est de préférence réalisée à température ambiante et à une pression de l'ordre de 100 mTorr, ou de l'ordre de 50 mTorr.

### Brève description des figures

D'autres caractéristiques et avantages de l'invention apparaîtront à l'aide de la description qui suit, donnée à titre illustratif et non limitatif, faite en regard des figures annexées parmi lesquelles :
[Fig. 1A] représente des nanofils verticaux en Ge₁₋ₓSnₓ avec x égal à 6% présentant des flancs de gravure à forte rugosité.
[Fig. 1B] représente des nanofils verticaux en Ge₁₋ₓSnₓ avec x égal à 6% présentant un fond de gravure non lisse comprenant des aiguilles.
[Fig. 1C] représente des nanofils verticaux en Ge₁₋ₓSnₓ avec x égal à 6% présentant des flancs de gravure à faible rugosité et un fond de gravure sans aiguilles, obtenus selon un premier mode de réalisation de l'invention.
[Fig. 2A] représente des nanofils verticaux en Ge₁₋ₓSnₓ avec x égal à 10% présentant des flancs de gravure à forte rugosité et un fond de gravure sans aiguilles.
[Fig. 2B] représente des nanofils verticaux en Ge₁₋ₓSnₓ avec x égal à 10% présentant des flancs de gravure à faible rugosité et un fond de gravure sans aiguilles, obtenus selon un deuxième mode de réalisation de l'invention.
[Fig. 3A] représente des nanofils verticaux en Ge₁₋ₓSnₓ avec x égal à 15% présentant des flancs de gravure à forte rugosité et un fond de gravure avec aiguilles.
[Fig. 3B] représente des nanofils verticaux en Ge₁₋ₓSnₓ avec x égal à 15% présentant des flancs de gravure à faible rugosité et un fond de gravure sans aiguilles, obtenus selon un troisième mode de réalisation de l'invention.
[Fig. 3C] représente des nanofils verticaux en Ge₁₋ₓSnₓ avec x égal à 15% présentant des flancs de gravure à faible rugosité et un fond de gravure sans aiguilles, obtenus selon un quatrième mode de réalisation de l'invention.
[Fig. 4A],
[Fig. 4B],
[Fig. 4C],

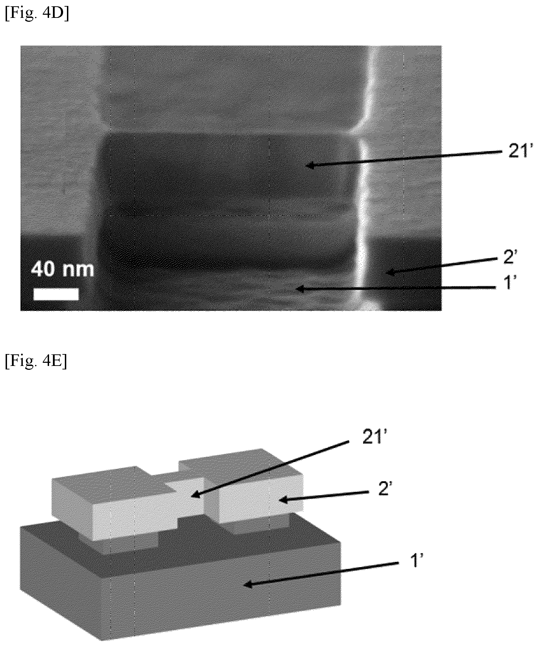

[Fig. 4D] et
[Fig. 4E] représentent un procédé de réalisation de nanofils horizontaux ou de dérives (fins) horizontales.

### Description détaillée de l'invention

### Fabrication de nanofils verticaux

Le procédé de fabrication dépend généralement du pourcentage x de Sn dans l'alliage Ge₁₋ₓSnₓ.

Pour les quatre modes de réalisation présentés ci-après, préalablement à la gravure, une couche de Ge₁₋ₓSnₓ est formée sur une couche de germanium (Ge). La couche de de Ge₁₋ₓSnₓ est formée par croissance épitaxiale, notamment par dépôt chimique en phase vapeur ou par jets moléculaires. Ensuite, une étape de dépôt d'un masque est réalisée sur le Ge₁₋ₓSnₓ, de préférence un masque dur. Par exemple, il peut s'agir d'un dépôt de résine Hydrogène Silsesquioxane (HSQ), dépôt réalisé par un procédé dit d'enduction centrifuge (« spin-coating » en anglais). Lorsque le procédé de gravure est terminé, la résine est enlevée, par exemple par une trempe dans de l'acide fluorhydrique (HF) dilué à quelques pourcentages ou dans une solution pour gravure d'oxyde tampon (« Buffer-Oxide-Etching » ou « BOE » en anglais), par exemple une solution avec un rapport volumique 6:1 entre le fluorure d'ammonium et l'acide fluorhydrique.

Le débit des gaz en donné en sccm, c'est-à-dire en cm³/min, à des conditions standard de température et de pression.

Dans tous les modes présentés ci-après, la température est généralement la température ambiante.

Selon un premier mode de réalisation, applicable notamment lorsque le pourcentage x en Sn dans l'alliage Ge₁₋ₓSnₓ est supérieur à 2% et inférieur à 8%, par exemple égal à 6%, on réalise une gravure plasma avec une chimie comprenant un mélange de dichlore (Cl₂), de diazote (N₂) et de dioxygène (O₂) à une pression inférieure ou égale à 10 mTorr.

La gravure est réalisée par exemple dans une chambre ICP-RIE (Plasma à Couplage Inductif-Gravure par Ions Réactifs pour « Inductively Coupled Plasma »-« Reactive-Ion Etching » en anglais). Dans ce cas, la pression donnée correspond à la pression dans la chambre.

Les débits de Cl₂, N₂, O₂ sont respectivement compris entre 15 et 20 sccm, 4 et 8 sccm, 10 et 15 sccm.

Les puissances de polarisation et de génération de plasma par ICP sont respectivement comprises entre 30 et 60 Watt et 30 et 60 Watt.

On obtient une vitesse de gravure comprise entre 2 et 4 nanomètres/seconde.

Cela permet d'obtenir des nanofils verticaux 2 en Ge₁₋ₓSnₓ tels que représentés en figure 1C, avec des flancs droits, bien verticaux, sans différence de gravure entre la couche 1 de Ge et la couche 2 de Ge₁₋ₓSnₓ, et qui respectent bien le profil de gravure imposé par le masque 3 en résine HSQ. En outre le fond de gravure 4 est exempt d'aiguilles.

Selon un deuxième mode de réalisation, applicable notamment lorsque le pourcentage x en Sn dans l'alliage Ge₁₋ₓSnₓ est supérieur ou égal à 8% et inférieur à 15%, par exemple égal à 10%, on réalise une gravure plasma avec une chimie comprenant un mélange de dichlore (Cl₂), de diazote (N₂) et de dioxygène (O₂) à une pression inférieure ou égale à 5 mTorr.

La gravure est réalisée par exemple dans une chambre ICP-RIE (« Inductively Coupled Plasma »- « Reactive-Ion Etching » en anglais). Dans ce cas, la pression donnée correspond à la pression dans la chambre.

Les débits de Cl₂, N₂, O₂ sont respectivement compris entre 15 et 20 sccm, 4 et 8 sccm, 10 et 15 sccm.

Les puissances de polarisation et de génération de plasma par ICP sont respectivement comprises entre 30 et 60 Watt et 30 et 60 Watt.

On obtient une vitesse de gravure comprise entre 2 et 4 nanomètres/seconde.

Cela permet d'obtenir des nanofils verticaux 2 en Ge₁₋ₓSnₓ tels que représentés en figure 2B, avec des flancs droits, bien verticaux, sans différence de gravure entre la couche 1 de Ge et la couche 2 de Ge₁₋ₓSnₓ, et qui respectent bien le profil de gravure imposé par le masque 3 en résine HSQ. En outre le fond de gravure 4 est exempt d'aiguilles. Le fait de diminuer la pression à 5 mTorr permet d'avoir un profil moins dégradé, en comparaison avec le profil représenté en figure 2A.

Selon un troisième mode de réalisation, applicable notamment lorsque le pourcentage x en Sn dans l'alliage Ge₁₋ₓSnₓ est supérieur ou égal à 15%, il est possible de réaliser une gravure plasma avec une chimie comprenant un mélange de dichlore (Cl₂) et de diazote (N₂), c'est-à-dire sans dioxygène (O₂), à une pression comprise entre 2 mTorr et 5 mTorr, avantageusement égale à 2 mTorr.

La gravure est réalisée par exemple dans une chambre ICP-RIE (« Inductively Coupled Plasma »- « Reactive-Ion Etching »). Dans ce cas, la pression donnée correspond à la pression dans la chambre.

Les débits de Cl₂ et N₂ sont respectivement compris entre 15 et 20 sccm et entre 4 et 8 sccm.

Les puissances de polarisation et de génération de plasma par ICP sont respectivement comprises entre 30 et 60 Watt et 30 et 60 Watt.

On obtient une vitesse de gravure comprise entre 2 et 4 nanomètres/seconde.

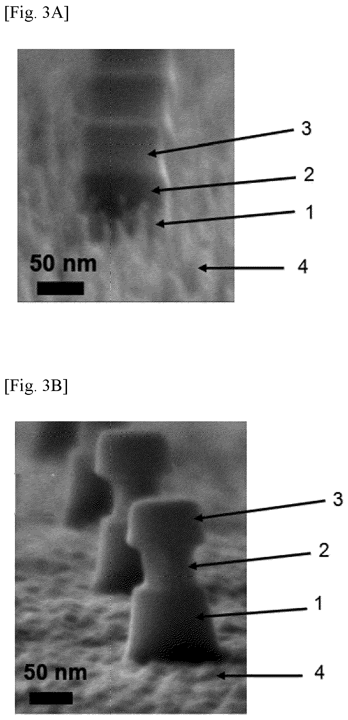

Cela permet d'obtenir des nanofils verticaux 2 en Ge₁₋ₓSnₓ tels que représentés en figure 3B, avec des flancs droits, bien verticaux. En outre le fond de gravure 4 est exempt d'aiguilles. Le fait de supprimer le dioxygène dans la chimie de plasma permet d'avoir un profil moins dégradé, en comparaison avec le profil représenté en figure 3A.

Selon un quatrième mode de réalisation, applicable notamment lorsque le pourcentage x en Sn dans l'alliage Ge₁₋ₓSnₓ est supérieur ou égal à 15%, il est possible de réaliser une gravure plasma avec une chimie comprenant un mélange de dichlore (Cl₂), de diazote (N₂) et de dioxygène (O₂), à une pression comprise entre 2 mTorr et 5 mTorr, avantageusement égale à 2 mTorr. Selon l'invention telle que revendiquée, préalablement à la gravure plasma, l'alliage Ge₁₋ₓSnₓ est traité à l'acide afin d'enlever l'oxyde natif ou chimique de l'étain.

Les débits de Cl₂, N₂, O₂ sont respectivement compris entre 15 et 20 sccm, 4 et 8 sccm, 10 et 15 sccm.

Les puissances de polarisation et d'ICP sont respectivement comprises entre 30 et 60 Watt et 30 et 60 Watt.

On obtient une vitesse de gravure comprise entre 2 et 4 nanomètres/seconde.

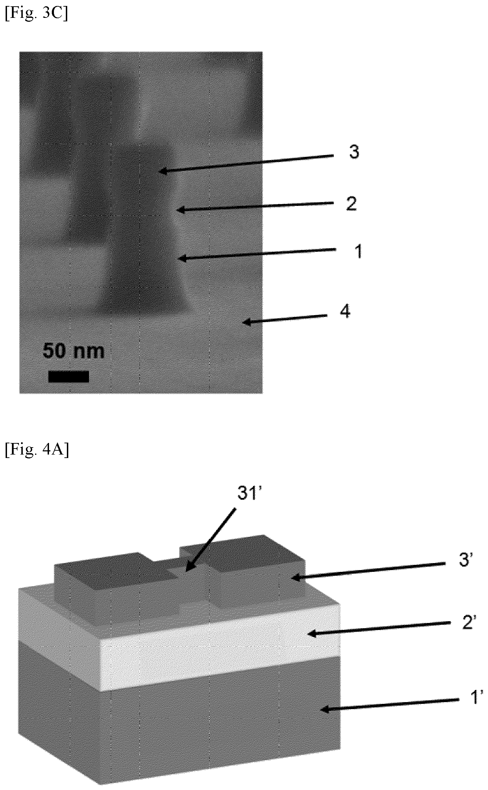

Cela permet d'obtenir des nanofils verticaux 2 en Ge₁₋ₓSnₓ tels que représentés en figure 3C, avec des flancs droits, bien verticaux, sans différence de gravure entre la couche 1 de Ge et la couche 2 de Ge₁₋ₓSnₓ, et qui respectent bien le profil de gravure imposé par le masque 3 en résine HSQ. En outre le fond de gravure 4 est exempt d'aiguilles. Le fait de réaliser un prétraitement à l'acide permet d'avoir un profil encore moins dégradé, en comparaison avec le profil représenté en figure 3A.

### Exemple de réalisation selon le quatrième mode de réalisation, avec x égal à 15%.

L'alliage Ge₁₋ₓSnₓ est exposé à de l'acide chlorhydrique (HCl), par exemple en le plongeant dans un bain d'HCl à température ambiante et à pression atmosphérique durant quelques minutes (par exemple 3 minutes), et sous légère agitation.

Ensuite, pendant la gravure plasma, la température est de 20°C. La puissance de polarisation est de 50 W. La puissance de l'ICP est de 50 W. La pression de gravure est de 2 mTorr. Le débit de Cl₂ est de 18 sccm. Le débit d'O₂ est de 5 sccm. Le débit de N₂ est de 13 sccm.

La vitesse de gravure obtenue est de l'ordre de 2,5 nanomètres/seconde.

### Fabrication de nanofils horizontaux ou de dérives (fins) horizontales

Un exemple de procédé de nanofils horizontaux ou de dérives (fins) horizontales est présenté dans les figures 4A à 4E.

Préalablement à la gravure, une couche de Ge₁₋ₓSnₓ est formée sur du Ge. La couche de de Ge₁₋ₓSnₓ est formée par croissance épitaxiale, notamment par dépôt chimique en phase vapeur ou par jets moléculaires.

Ensuite, une étape de dépôt d'un masque est réalisée sur le Ge₁₋ₓSnₓ, de préférence un masque dur. Par exemple, il peut s'agir d'un dépôt de résine Hydrogène Silsesquioxane (HSQ) par lithographie électronique.

On obtient typiquement une structure du type celle présentée en figure 4A avec une couche 1' de Ge de l'ordre de 1,2 µm d'épaisseur, sur laquelle est disposée une couche 2' de Ge₁₋ₓSnₓ de l'ordre de 50 nm d'épaisseur et un masque 3' en HSQ qui comprend notamment la forme de la dérive 31' recherchée.

Une première gravure plasma est réalisée selon le procédé de gravure de l'invention, notamment selon un des quatre modes décrits précédemment. Les conditions de gravure décrites précédemment (modes de réalisation, exemple de réalisation) peuvent également être appliquées. En particulier, les puissances de polarisation et de génération de plasma par ICP peuvent être égales à 50 Watt.

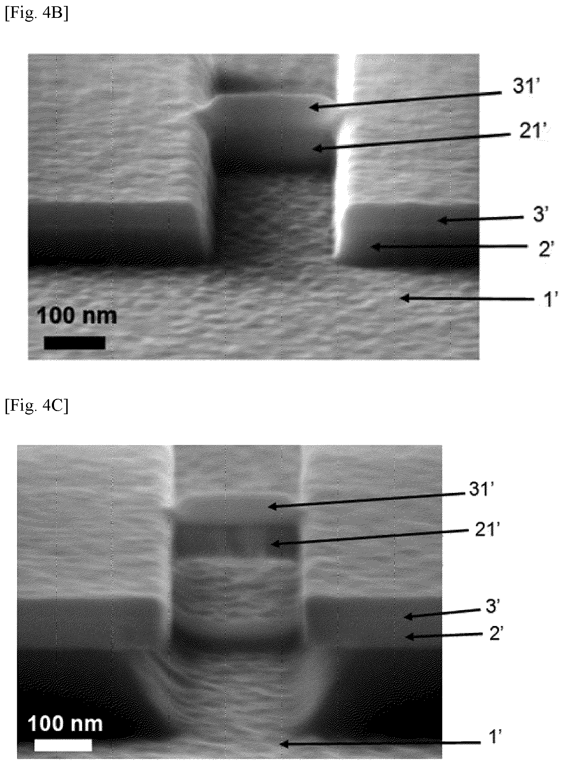

On obtient ainsi une structure du type de celle présentée en figure 4B dans laquelle la couche 2' de Ge₁₋ₓSnₓ a été gravée pour former une dérive 21' en Ge₁₋ₓSnₓ. Sur la couche de Ge₁₋ₓSnₓ ainsi gravée, le masque 3' en HSQ avec la forme de dérive 31' est encore présent, et toute la couche de Ge₁₋ₓSnₓ est encore en contact avec la couche 1' de Ge.

Une seconde gravure plasma est ensuite réalisée en utilisant du CF₄. Cette seconde gravure peut être désignée par « gravure sélective » dans la mesure où elle vise à graver le germanium (Ge), et non le GeSn.

Selon un exemple de réalisation, on peut choisir un débit de CF₄ égal à 100 sccm, à une pression de 50 mTorr, à la température ambiante, une puissance ICP de 500 Watt et puissance de polarisation de 5 Watt afin de graver préférentiellement le germanium (Ge) en laissant le GeSn intact.

On obtient une structure du type celle présentée en figure 4C dans laquelle la couche 1' de Ge a été gravée en dessous de la dérive 21' en Ge₁₋ₓSnₓ. Une partie de la couche 2' de Ge₁₋ₓSnₓ n'est ainsi plus en contact avec la couche 1' de Ge, plus précisément au niveau de la dérive 21' en Ge₁₋ₓSnₓ. Le masque 3' en HSQ avec la forme de dérive 31' du masque est encore présent.

Enfin, la résine en HSQ est enlevée, par exemple avec un bain d'acide fluorhydrique (HF) ou dans une solution dite « Buffer-Oxide-Etching » comme décrite plus avant.

On obtient une structure du type celle présentée en figure 4D dans laquelle le masque en HSQ a été enlevé.

La présente invention n'est pas limitée aux modes de réalisation précédemment décrits mais s'étend à tout mode de réalisation entrant dans la portée des revendications.

L'invention permet de réaliser des dérives (fins) ou des nanofils verticaux ou horizontaux à base de GeSn de dimensions de l'ordre de la dizaine de nanomètres à quelques dizaines de nanomètres. L'invention s'applique notamment à la réalisation de canaux de conduction pour des transistors FinFET (« Fin Field Effect Transistor »), GAAFET (« Gate All Around Field Effect Transistor », ou transistors FET à grille enrobante), ou encore Tunnel FET (TFET).

De manière générale, l'invention s'applique à la réalisation de transistors FET avantageusement destinés à des applications logiques à hautes performances et basse consommation de la microélectronique, et/ou pouvant être utilisé pour des applications Internet des Objets « IoT » (« Internet Of Things » en anglais).

## Revendications

1. Procédé de gravure à l'échelle nanométrique d'une couche de Ge₁₋ₓSnₓ sur un support pour transistor FET, x étant la concentration en étain et étant sensiblement inférieure à 30%, le procédé de gravure étant **caractérisé en ce qu'**il comprend :
- une étape de retrait de l'oxyde natif ou chimique de l'étain ; et
- une étape de gravure plasma de ladite couche de Ge₁₋ₓSnₓ avec un mélange comprenant du dichlore, Cl₂, et du diazote, N₂, t-Nrf et sous une pression de gravure inférieure ou égale à 50 mTorr, de préférence inférieure ou égale à 10 mTorr, ce qui correspond à 1,333 Pa ladite étape de retrait étant antérieure à ladite étape de gravure plasma.

2. Procédé de gravure selon la revendication 1, la concentration x en étain dans le Ge₁₋ₓSnₓ étant supérieure à 5 %, de préférence supérieure ou égale à 10%.

3. Procédé de gravure selon l'une des revendications 1 ou 2, la pression de gravure étant inférieure ou égale à 10 mTorr, ce qui correspond à 1,333 Pa, pour une concentration x en étain inférieure à 8%, et 5 mTorr, ce qui correspond à 0,666 Pa, pour une concentration x en étain supérieure ou égale à 8%.

4. Procédé de gravure selon la revendication 3, la pression de gravure étant inférieure ou égale à 2 mTorr, ce qui correspond à 0,2666 Pa, pour une concentration x en étain supérieure ou égale à 15%.

5. Procédé de gravure selon l'une quelconque des revendications précédentes, le mélange comprenant en outre du dioxygène, O₂.

6. Procédé de gravure selon l'une des revendications précédentes, l'étape de retrait consistant en une attaque chimique acide, l'acide étant de préférence de l'acide fluorhydrique, HF, ou de l'acide chlorhydrique, HCL.

7. Procédé de gravure selon l'une quelconque des revendications précédentes comprenant en outre une étape de dépôt d'un masque sur la couche de Ge₁₋ₓSnₓ, de préférence un masque dur, par exemple un masque en résine Hydrogène Silsesquioxane, HSQ, ladite étape de dépôt étant antérieure à l'étape de gravure plasma du Ge₁₋ₓSnₓ.

8. Procédé de gravure selon la revendication 7 comprenant en outre une étape d'élimination du masque, ladite étape d'élimination étant postérieure à l'étape de gravure plasma du Ge₁₋ₓSnₓ.

9. Procédé de fabrication d'au moins un canal de conduction sur un support pour transistor FET, ledit procédé de fabrication comprenant les étapes suivantes :
- une étape de formation d'une couche en Ge₁₋ₓSnₓ sur ledit support, ladite couche étant réalisée par croissance épitaxiale ; et
- une étape de gravure de la couche de Ge₁₋ₓSnₓ réalisée selon le procédé décrit dans une des revendications 1 à 8

10. Procédé de fabrication selon la revendication 9, la surface libre du support comprenant une couche de Ge de sorte que la couche de Ge₁₋ₓSnₓ soit formée sur la couche de Ge, le procédé de fabrication comprenant en outre une étape de gravure plasma sélective de la couche de Ge, ladite étape de gravure plasma sélective étant réalisée de préférence avec du tétrafluorure de carbone, CF₄, et étant postérieure à l'étape de gravure du Ge₁₋ₓSnₓ.

## Patentansprüche

1. Verfahren zum Ätzen im Nanometerbereich einer Schicht aus Ge₁₋ₓSnₓ auf einem Träger für einen FET-Transistor, wobei x die Konzentration von Zinn und wesentlich niedriger als 30 % ist, wobei das Ätzverfahren **dadurch gekennzeichnet ist, dass** es Folgendes umfasst:
- einen Schritt des Entfernens des nativen oder chemischen Oxids des Zinns; und
- einen Schritt des Plasmaätzens der Ge₁₋ₓSnₓ-Schicht mit einem Gemisch, das Dichlor, Cl₂, und Distickstoff, N₂, umfasst, und unter einem Ätzdruck von gleich oder kleiner als 50 mTorr, vorzugsweise gleich oder kleiner als 10 mTorr, was 1,333 Pa entspricht, wobei der Entfernungsschritt vor dem Plasmaätzschritt erfolgt.

2. Ätzverfahren nach Anspruch 1, wobei die Konzentration x von Zinn im Ge₁₋ₓSnₓ größer als 5 %, vorzugsweise gleich oder größer als 10 % ist.

3. Ätzverfahren nach einem der Ansprüche 1 oder 2, wobei der Ätzdruck gleich oder kleiner als 10 mTorr, was 1,333 Pa entspricht, für eine Konzentration x von Zinn von weniger als 8 %, und 5 mTorr, was 0,666 Pa entspricht, für eine Konzentration x von Zinn von gleich oder größer als 8 % ist.

4. Ätzverfahren nach Anspruch 3, wobei der Ätzdruck gleich oder kleiner als 2 mTorr, was 0,2666 Pa entspricht, für eine Konzentration x von Zinn von gleich oder größer als 15 % ist.

5. Ätzverfahren nach einem der vorhergehenden Ansprüche, wobei das Gemisch ferner Disauerstoff, O₂, umfasst.

6. Ätzverfahren nach einem der vorhergehenden Ansprüche, wobei der Entfernungsschritt aus einer chemischen Säureätzung besteht, wobei die Säure vorzugsweise Fluorwasserstoffsäure, HF, oder Salzsäure, HCl, ist.

7. Ätzverfahren nach einem der vorhergehenden Ansprüche, das ferner einen Schritt des Abscheidens einer Maske auf die Ge₁₋ₓSnₓ-Schicht, vorzugsweise eine harte Maske, beispielsweise eine Maske aus Wasserstoffsilsesquioxan-Harz, HSQ, umfasst, wobei der Abscheidungsschritt vor dem Schritt des Plasmaätzens des Ge₁₋ₓSnₓ erfolgt.

8. Ätzverfahren nach Anspruch 7, das ferner einen Schritt des Entfernens der Maske umfasst, wobei der Schritt des Entfernens nach dem Plasmaätzschritt des Ge₁₋ₓSnₓ erfolgt.

9. Verfahren zur Herstellung von mindestens einem Leitungskanal auf einem Träger für einen FET-Transistor, wobei das Herstellungsverfahren die folgenden Schritte umfasst:
- einen Schritt des Bildens einer Schicht aus Ge₁₋ₓSnₓ auf dem Träger, wobei die Schicht durch epitaktisches Wachstum hergestellt wird; und
- einen Schritt des Ätzens der Ge₁₋ₓSnₓ-Schicht, die nach dem in einem der Ansprüche 1 bis 8 beschriebenen Verfahren durchgeführt wird.

10. Herstellungsverfahren nach Anspruch 9, wobei die freie Oberfläche des Trägers eine Ge-Schicht umfasst, so dass die Ge₁₋ₓSnₓ-Schicht auf der Ge-Schicht gebildet wird, wobei das Herstellungsverfahren außerdem einen Schritt des selektiven Plasmaätzens der Ge-Schicht umfasst, wobei der Schritt des selektiven Plasmaätzens vorzugsweise mit Kohlenstofftetrafluorid, CF₄, durchgeführt wird und nach dem Schritt des Ätzens von Ge₁₋ₓSnₓ erfolgt.

## Claims

1. A method for the nanoscale etching of a layer of Ge₁₋ₓSnₓ on a carrier for a FET transistor, x being the concentration of tin and being substantially lower than 30%, the etching method being **characterised in that** it comprises:
- a step of removing the chemical or native oxide from the tin; and
- a step of plasma-etching said layer of Ge₁₋ₓSnₓ with a mixture comprising dichlorine, Cl₂, and dinitrogen, N₂, and under an etching pressure lower than or equal to 50 mTorr, preferably lower than or equal to 10 mTorr, which corresponds to 1.333 Pa; said removal step being anterior to said plasma-etching step.

2. The etching method according to claim 1, the concentration x of tin in the Ge₁₋ₓSnₓ being higher than 5%, preferably higher than or equal to 10%.

3. The etching method according to one of claims 1 or 2, the etching pressure being lower than or equal to 10 mTorr, which corresponds to 1.333 Pa, for a concentration x of tin lower than 8%, and 5 mTorr, which corresponds to 0.666 Pa, for a concentration x of tin higher than or equal to 8%.

4. The etching method according to claim 3, the etching pressure being lower than or equal to 2 mTorr, which corresponds to 0.2666 Pa, for a concentration x of tin higher than or equal to 15%.

5. The etching method according to any one of the preceding claims, the mixture further comprising dioxygen, O₂.

6. The etching method according to any one of the preceding claims, the removal step consisting of an acid chemical attack, the acid preferably being hydrofluoric acid, HF, or hydrochloric acid ,HCl.

7. The etching method according to any one of the preceding claims, further comprising a step of depositing a mask on the layer of Ge₁₋ₓSnₓ, preferably a hard mask, for example a mask made of hydrogen silsesquioxane, HSQ, resin, said deposition step coming before the step of plasma-etching the Ge₁₋ₓSnₓ.

8. The etching method according to claim 7, further comprising a step of removing the mask, said removal step coming after the step of plasma-etching the Ge₁₋ₓSnₓ.

9. A method for producing at least one conduction channel on a carrier for a FET transistor, said production method comprising the following steps:
- a step of forming a layer of Ge₁₋ₓSnₓ on said carrier, said layer being produced by epitaxial growth; and
- a step of etching the layer of Ge₁₋ₓSnₓ produced according to the method described in one of claims 1 to 8.

10. A production method according to claim 9, the free surface of the carrier comprising a layer of Ge such that the layer of Ge₁₋ₓSnₓ is formed on the layer of Ge, the production method further comprising a step of selectively plasma-etching the layer of Ge, said selective plasma-etching step preferably being performed using carbon tetrafluoride, CF₄, and coming after the step of etching the Ge₁₋ₓSnₓ.
